# EUROPEAN PATENT APPLICATION

(11) **EP 4 535 081 A2**
(43) Date of publication of application: **09.04.2025**
(21) Application number: 24199377.3
(22) Date of filing: 10.09.2024
(51) Int. Cl.: G03F 7/00

(54) **MOLD, MANUFACTURING METHOD, FILM FORMING METHOD, ARTICLE MANUFACTURING METHOD, AND IMPRINT APPARATUS**

(30) Priority: 15.09.2023 JP 2023150284
(71) Applicant: CANON KABUSHIKI KAISHA, Tokyo 146-8501 (JP)
(72) Inventor: ITO, Toshiki, Tokyo (JP); KATSUTA, Ken, Tokyo (JP); OKADA, Tetsuji, Tokyo (JP)
(74) Representative: WESER & Kollegen Patentanwälte PartmbB

(57) **Abstract**

A mold including a first part and a second part, wherein the first part includes a first surface and a second surface on an opposite side of the first surface, the second surface includes a concave portion having a concave shape, the first surface includes a convex portion and having a convex shape, the second part includes a third surface combined to the convex portion of the first part, and a fourth surface on the opposite side of the third surface, on which a pattern to be transferred to a transfer target is formed, the first part is made of a material having a first elastic modulus, and the second part is made of a material having a second elastic modulus lower than the first elastic modulus.

## Description

### BACKGROUND OF THE INVENTION

### Field of the Invention

The present invention relates to a mold, a manufacturing method, a film forming method and an article manufacturing method, and an imprint apparatus.

### Description of the Related Art

For optical members, recording media, semiconductor devices, and MEMS, requirements of micronization are increasing, and as a micropatterning technique, an imprint technique (optical imprint technique) has received a great deal of attention as a microfabrication technique. In the imprint technique, a curable composition is cured in a state in which a mold with a fine concave-convex pattern formed on the surface is in contact with the curable composition supplied (applied) onto a substrate. Thus, the pattern of the mold is transferred to the cured film of the curable composition, thereby forming the pattern on the substrate. According to the imprint technique, it is possible to form, on a substrate, a fine pattern (structure) on a several nanometer order.

A master mold used in the imprint technique is very expensive because a fine pattern is formed on the surface of silicon, silica glass, a metal, or the like by precision machining. Hence, Japanese Patent No. 5139421 proposes a technique of manufacturing a replica mold by transferring the fine pattern of the master mold to a mold base material (for example, silica glass) by imprint processing (replica imprint) and etching processing. The replica mold is used in imprint processing (device imprint) for manufacturing various kinds of devices.

When manufacturing various kinds of devices, particularly, optical members, a foreign substance of about 1 µm to 10 µm may exist on a substrate (device substrate). If device imprint is executed for the substrate with the foreign substance using a replica mold made of silica glass, which is manufactured by the technique disclosed in Japanese Patent No. 5139421, a noncontact region of several mm to several tens of mm occurs with respect to the foreign substance as the center. Here, since the noncontact region is a region where a curable composition on the substrate and the replica mold are not in contact, the pattern of the replica mold is not transferred to the noncontact region, and the pattern is not formed. Note that the noncontact region can be reduced by applying a strong force (pressing force) to the replica mold, but the possibility that the pattern of the replica mold is compressed by the foreign substance and broken is high.

### SUMMARY OF THE INVENTION

The present invention provides a new technique concerning a mold.

The present invention in its first aspect provides a mold as specified in claims 1 to 9.

The present invention in its second aspect provides a manufacturing method of manufacturing a mold as specified in claim 10.

The present invention in its third aspect provides a film forming method as specified in claim 11.

The present invention in its fourth aspect provides an article manufacturing method as specified in claim 12.

The present invention in its fifth aspect provides an imprint apparatus as specified in claim 13.

Further aspects of the present invention will become apparent from the following description of exemplary embodiments with reference to the attached drawings.

### BRIEF DESCRIPTION OF THE DRAWINGS

Fig. 1 is a view for describing the configuration of a replica mold according to an aspect of the present invention.
Fig. 2 is a view for describing the configuration of a replica mold according to an aspect of the present invention.
Fig. 3 is a view for describing the configuration of a replica mold according to an aspect of the present invention.
Figs. 4A to 4H are flowcharts for describing a manufacturing method of manufacturing the replica mold.
Figs. 5A to 5D are views illustrating the configurations of replica molds according to Example 1 and Comparative Examples 1, 2, and 3.
Figs. 6A to 6D are views for describing a contact step of imprint processing.
Fig. 7 is a view for describing an analysis model of the following behavior of the replica mold to a foreign substance.
Fig. 8 is a view for describing the difference of the following behavior of the replica mold to a foreign substance between Example 1 and Comparative Example 2.
Fig. 9 is a schematic view illustrating configurations of an imprint apparatus according to an aspect of the present invention.
Figs. 10A to 10F are views for describing an article manufacturing method.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

### [Replica Mold]

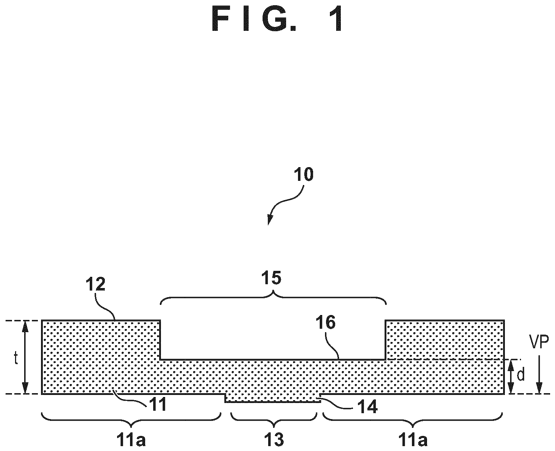

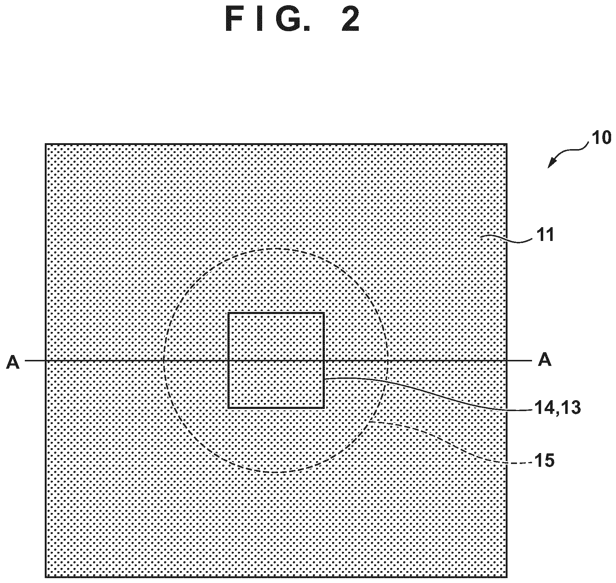

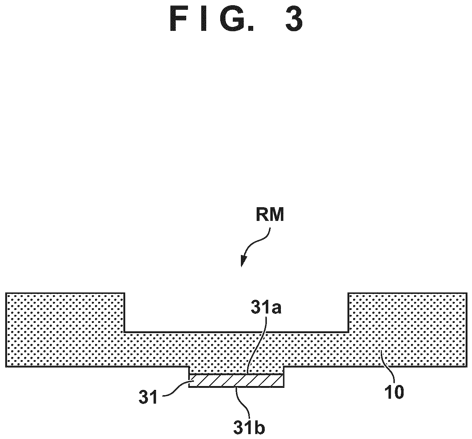

Figs. 1, 2, and 3 are views for describing the configuration of a replica mold RM according to an aspect of the present invention. The replica mold RM is a mold (a mold, a template, or an original) used in (an imprint apparatus employing) an imprint technique and is embodied as a replica mold manufactured from a master mold in this embodiment. As shown in Fig. 3, the replica mold RM includes a high elastic modulus part 10 (first part) made of a high elastic modulus material having a first elastic modulus, and a low elastic modulus part 31 (second part) made of a low elastic modulus material having a second elastic modulus lower than the first elastic modulus. The high elastic modulus part 10 (high elastic modulus material) has an elastic modulus of 20 GPa or more, preferably has an elastic modulus of 50 GPa or more, and particularly preferably has an elastic modulus of 70 GPa or more. The higher the elastic modulus (first elastic modulus) of the high elastic modulus part 10 is, the more a pressing force is transmitted to the low elastic modulus part 31. The low elastic modulus part 31 (low elastic modulus material) has an elastic modulus of 10 GPa or less, preferably has an elastic modulus of 3 GPa or less, and particularly preferably has an elastic modulus of 1 GPa or less. The lower the elastic modulus (second elastic modulus) of the low elastic modulus part 31 is, the higher the followability to a foreign substance existing on a transfer target to transfer the pattern of the replica mold RM is. Fig. 1 is a sectional view schematically showing the high elastic modulus part 10, and Fig. 2 is a plan view schematically showing the high elastic modulus part 10. Note that a sectional view taken along a line A - A in Fig. 2 is Fig. 1. Fig. 3 is a sectional view schematically showing the replica mold RM having the high elastic modulus part 10 and the low elastic modulus part 31.

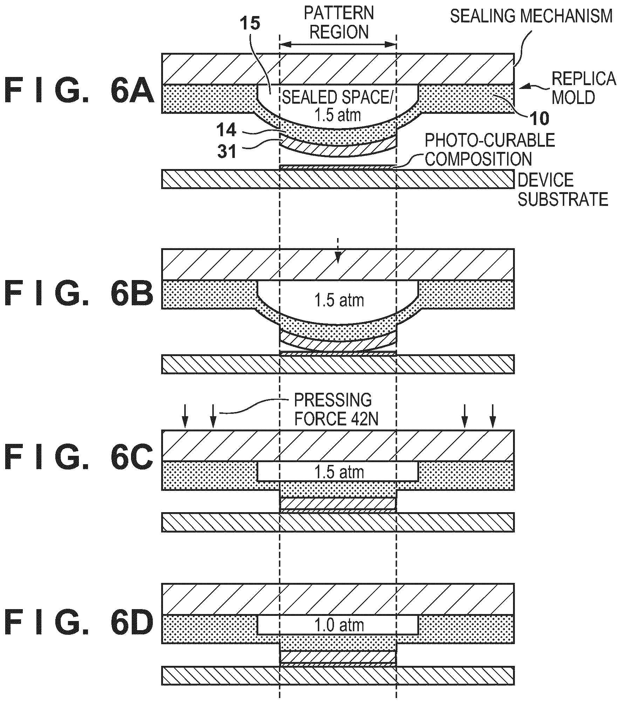

As shown in Figs. 1 and 2, the high elastic modulus part 10 is made of a replica base material that is the base material of the replica mold. As shown in Fig. 1, the high elastic modulus part 10 includes a first surface 11 including a plane 11a, and a second surface 12 on the opposite side of the first surface 11. The first surface 11 includes a convex portion 14 that projects from the plane 11a to the opposite side of the second surface 12 to form a convex shape, that is, a step structure (so-called mesa structure) higher than the periphery. The convex portion 14 is formed at the center portion of the first surface 11 and defines a pattern region 13 where a transfer pattern to be transferred to the transfer target should be formed. The convex portion 14 has an area, for example, 0.5% or more and 30% or less the area of the first surface 11. The convex portion 14 has a height of, for example, 1 µm or more and 1,000 µm or less from the first surface 11. On the other hand, the second surface 12 includes a concave portion 15 having a concave shape on the side of the first surface 11, as shown in Fig. 1. The concave portion 15 is formed at the center portion of the second surface 12 such that a distance d between the plane 11a of the first surface 11 and the bottom surface of the concave portion 15 (that is, the thickness of the bottom portion) is 0.1 mm or more and 3 mm or less. If the distance d is shorter than 0.1 mm (the thickness of the bottom portion of the concave portion 15 is small), the replica mold RM (high elastic modulus part 10) readily breaks. If the distance d is longer than 3 mm (the thickness of the bottom portion of the concave portion 15 is large), a large pressure is needed to bend the concave portion 15 (see Fig. 6A). The distance d is preferably 0.5 mm or more and 2.0 mm or less, and particularly preferably 0.8 mm or more and 1.5 mm or less. As shown in Figs. 1 and 2, the concave portion 15 is formed in the second surface 12 such that a region (a circle indicated by a dotted line) formed by orthogonally projecting the concave portion 15 to a virtual plane VP parallel to the first surface 11, more specifically, the plane 11a overlaps the convex portion 14 (pattern region 13) formed on the first surface 11. Furthermore, the concave portion 15 is formed in the second surface 12 such that the region formed by orthogonally projecting the concave portion 15 to the virtual plane VP has an area larger than the area of the convex portion 14. In other words, the convex portion 14 is located in a region inside the outer edge of the region formed by orthogonally projecting the concave portion 15 to the virtual plane VP. Also, the maximum thickness of the high elastic modulus part 10, more specifically, a distance t between the plane 1 1a of the first surface 11 and a portion of the second surface 12 without the concave portion is 6.35 mm (0.25 inches) ± 0.10 mm.

As shown in Fig. 3, the low elastic modulus part 31 includes a third surface 31a combined to the convex portion 14 of the high elastic modulus part 10, and a fourth surface 31b on the opposite side of the third surface 31a. The low elastic modulus part 31 is combined to (formed on) the first surface 11 of the high elastic modulus part 10, more specifically, the convex portion 14 (pattern region 13) formed on the first surface 11 via the third surface 31a. When forming the low elastic modulus part 31 on the convex portion 14, an imprint method is used. By the imprint method, the low elastic modulus part 31 is formed on the convex portion 14, and the transfer pattern to be transferred to the transfer target is formed on the fourth surface 31b of the low elastic modulus part 31. The low elastic modulus part 31 has a thickness of, for example, 0.1 µm or more and 1,000 µm or less.

### [Replica Mold Manufacturing Method]

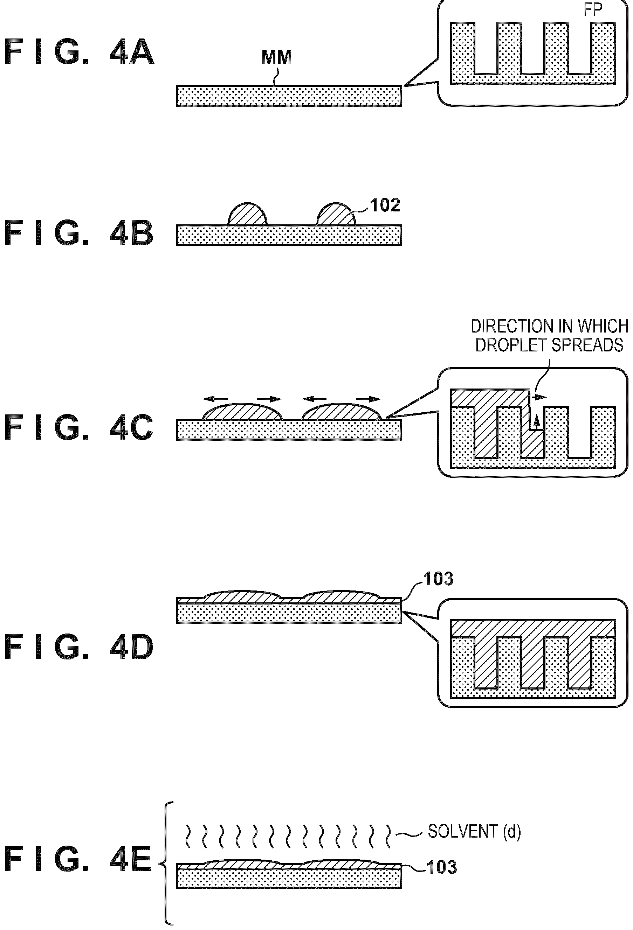

A manufacturing method of manufacturing the replica mold RM includes a step of forming the low elastic modulus part 31 on the convex portion 14 formed on the first surface 11 of the high elastic modulus part 10 using an imprint method. The step (imprint method) includes a preparation step of a master mold, a preparation step of a curable composition (A) that is a low elastic modulus member, an arranging step, a contact step, a curing step, and a mold release step. The manufacturing method of manufacturing the replica mold RM will be described below with reference to Figs. 4A to 4H, particularly focusing on a step of forming the low elastic modulus part 31.

### <Preparation Step of Master Mold>

As schematically shown in Fig. 4A, a master mold MM is prepared. The master mold MM has a fine pattern FP on its surface. The fine pattern FP is an inverted pattern obtained by inverting the concave-convex structure of a pattern to be formed on the replica mold RM. As the master mold MM, a mold made of a non-light transmitting material or a mold made of a light transmitting material can be used. Examples of the mold base material of the mold made of a non-light transmitting material are a silicon wafer, nickel, copper, stainless steel, titanium, SiC, and mica. Examples of the mold base material of the mold made of a light transmitting material are glass such as silica glass, polydimethylsiloxane, cyclic polyolefin, polycarbonate, polyethylene terephthalate, and transparent fluororesin. The mold made of a light transmitting material may be made of a plurality of materials. Note that as the mold base material of the master mold MM, a silicon wafer or a quartz wafer is preferable because materials having high quality and high use result in the semiconductor industry are available.

The fine pattern FP of the master mold MM is formed using, for example, a micropatterning technique such as an electron beam lithography technique. The fine pattern FP formed on the master mold MM has a height of, for example, 4 nm or more and 200 nm or less. As the height of the fine pattern FP of the master mold MM decreases, it becomes possible to decrease the force necessary for releasing the master mold MM from the cured film of a curable composition (A), that is, the mold release force in the mold release step. Hence, it is possible to decrease the number of mold release defects remaining in the master mold MM because the pattern of the curable composition (A) is torn off. Also, in some cases, the pattern of the curable composition (A) elastically deforms due to the impact when the master mold MM is released, and adjacent pattern elements come in contact with each other and adhere to each other or break each other. Note that to avoid these defects, it is advantageous to make the height of pattern elements be about twice or less the width of the pattern elements (make the aspect ratio be 2 or less). On the other hand, if the height of pattern elements is too small, the processing accuracy of the mold base material decreases.

A surface treatment can also be performed on the master mold MM before performing the arranging step, in order to improve the detachability of the master mold MM with respect to the curable composition (A). An example of this surface treatment is to form a mold release agent layer by coating the surface of the master mold MM with a mold release agent. Examples of the mold release agent to be applied on the surface of the master mold MM are a silicon-based mold release agent, a fluorine-based mold release agent, a hydrocarbon-based mold release agent, a polyethylene-based mold release agent, a polypropylene-based mold release agent, a paraffine-based mold release agent, a montane-based mold release agent, and a carnauba-based mold release agent. It is also possible to suitably use a commercially available coating-type mold release agent such as Optool^{®} DSX manufactured by Daikin. Note that it is possible to use one type of a mold release agent alone, or use two or more types of mold release agents together. Of the mold release agents described above, fluorine-based and hydrocarbon-based mold release agents are particularly favorable.

### <Preparation Step of Curable Composition (A)>

The curable composition (A) as a low elastic modulus member is prepared. The curable composition (A) is a composition containing at least a polymerizable compound (a), and a photopolymerization initiator (b). The curable composition (A) may be a composition further containing a nonpolymerizable compound (c), and a solvent (d). The curable composition (A) is a curable composition for inkjet.

The polymerizable compound (a) may further contain at least one of a component (as) that is a silicon compound having polymerizability, and a component (at) that is a fluorine compound having polymerizability.

A silicon compound as the component (as) may be understood as a silicon-containing polymerizable compound. In this specification, the silicon-containing polymerizable compound is a compound that reacts with a polymerizing factor (for example, a radical) generated from the photopolymerization initiator (b), and forms a film made of a polymer compound by a chain reaction (polymerization reaction).

An example of the silicon-containing polymerizable compound is a radical polymerizable compound. The polymerizable compound as the component (as) can be formed by only one type of a polymerizable compound, and can also be formed by a plurality of types of polymerizable compounds.

Examples of the silicon-containing radical polymerizable compound are a (meth)acrylate-based compound, a (meth)acrylamide-based compound, a vinylbenzene-based compound, an aryl ether-based compound, a vinyl ether-based compound, and a maleimide-based compound.

The silicon-containing polymerizable compound can be linear or branched. Detailed examples of the radical polymerizable functional group are a (meth)acrylate-based compound, a (meth)acrylamide-based compound, a vinylbenzene-based compound, an aryl ether-based compound, a vinyl ether-based compound, and a maleimide-based compound.

Examples of the commercially available products of the silicon-containing monofunctional (meth)acrylic compounds are as follows, but the products are not limited to these examples.

SIA0160.0, SIA0180.0, SIA0182.0, SIA0184.0, SIA0186.0, SIA0190.0, SIA0194.0, SIA0196.0, SIA0197.0, SIA0198.0, SIA0199.0, SIA0200.0, SIA0200.A1, SIA0210.0, SIA0315.0, SIA0320.0, SIM6483.0, SIM6487.5, SIM6480.76, SIM6481.2, SIM6486.1, SIM6481.1, SIM6481.46, SIM6481.43, SIM6482.0, SIM6487.4, SIM6487.35, SIM6480.8, SIM6486.9, SIM6486.8, SIM6486.5, SIM6486.4, SIM6481.3, SIM6487.3, SIM6487.1, SIM6487.6, SIM6486.14, SIM6481.48, SIM6481.5, SIM6491.0, SIM6485.6, SIM6481.15, SIM6487.0, SIM6481.05, SIM6485.8, SIM6481.0, SIM6487.4LI, SIM6481.16, SIM6487.8, SIM6487.6HP, SIM6487.17, SIM6486.7, SIM6487.2, SIM6486.0, SIM6486.2, SIM6487.6-06, SIM6487.6-20, SIM6485.9, SST-R8C42, SLT-3R01, and SIM6486.65 (manufactured by GELEST), and TM-0701T, FM-0711, FM-0721, and FM-0725 (manufactured by JNC)

Examples of a polyfunctional (meth)acrylate-based compound having two or more acryloyl groups or methacryloyl groups are as follows, but the compound is not limited to these examples.

linear polydimethylsiloxane modified on both ends with acryloxypropyl groups,
linear polydimethylsiloxane modified on both ends with methacryloxypropyl groups,
cyclic siloxane modified with multiple acryloxypropyl groups,
cyclic siloxane modified with multiple methacryloxypropyl groups,
silsesquioxane modified with multiple acryloxypropyl groups, and
silsesquioxane modified with multiple methacryloxypropyl groups

Examples of the commercially available products of the above-described silicon-containing polyfunctional (meth) acrylate compounds are as follows, but the products are not limited to these examples.

SIA0200.2, SIA0200.3, SIM6487.42, DMS-R11, DMS-R05, DMS-R22, DMS-R18, DMS-R31 (manufactured by GELEST), FM-7711, FM-7721, FM-7725 (manufactured by JNC), X-22-2445 (manufactured by Shin-Etsu Chemical), and AC-SQ TA-100, MAC-SQ TM-100, AC-SQ SI-20, MAC-SQ SI-20 (manufactured by TOAGOSEI)

A silicon-containing (meth)acrylamide-based compound is a compound having one or more acrylamide groups or methacrylamide groups. Examples of a silicon-containing (meth)acrylamide-based compound having one acrylamide group or methacrylamide group are as follows, but the compound is not limited to these examples.

3-acrylamidopropyltrimethoxysilane, and 3-acrylamidopropyltris(trimethylsiloxy)silane

Examples of the commercially available products of the above-described silicon-containing (meth)acrylamide compounds are as follows, but the products are not limited to these examples.

SIA0146.0, and SIA0150.0 (manufactured by GELEST)

A fluorine compound as the component (at) may be understood as a fluorine-containing polymerizable compound. In this specification, the fluorine-containing polymerizable compound is a compound that reacts with a polymerizing factor (for example, a radical) generated from the photopolymerization initiator (b), and forms a film made of a polymer compound by a chain reaction (polymerization reaction).

An example of the fluorine-containing polymerizable compound is a radical polymerizable compound. The polymerizable compound as the component (at) can be formed by only one type of a polymerizable compound, and can also be formed by a plurality of types (one or more types) of polymerizable compounds.

Examples of the fluorine-containing radical polymerizable compound are a (meth)acrylate-based compound, a (meth)acrylamide-based compound, a vinylbenzene-based compound, an aryl ether-based compound, a vinyl ether-based compound, and a maleimide-based compound.

Examples of the commercially available products of the above-described fluorine-containing monofunctional (meth)acrylate-based compounds are as follows, but the products are not limited to these examples.

2,2,2-trifluoroethyl acrylate, 2,2,3,4,4,4-hexafluorobutyl methacrylate, 1,1,1,3,3,3-hexafluoroisopropyl acrylate, 2,2,3,3,4,4,4-heptafluorobutyl methacrylate, 2,2,2-trifluoroethyl methacrylate, 1,1,1,3,3,3-hexafluoroisopropyl methacrylate, 1H,1H,2H,2H-nonafluorohexyl methacrylate, 1H,1H,2H,2H-nonafluorohexyl acrylate, 1H,1H,2H,2H-nonafluorohexyl methacrylate, 1H,1H,5H -octafluoropentyl acrylate, pentafluorophenyl acrylate, 2,2,3,3,3-pentafluoropropyl methacrylate, pentafluorobenzyl methacrylate, 2,2,3,3-tetrafluoropropyl acrylate, 1H,1H,2H,2H-tridecafluoro-n-octyl methacrylate, 1H,1H,2H,2H-tridecafluoro-n-octyl acrylate, 2,2,3,3-tetrafluoropropyl methacrylate, 1H,1H,2H,2H-heptadecafluorodecyl acrylate, 2,2,3,3,4,4,5,5,6,6,7, 7-dodecafluoroheptyl acrylate, 2,2,3,3,4,4,5,5,6,6,7,7-dodecafluoroheptyl methacrylate, 1H,1H,5H-octafluoropentyl acrylate, meth Pentafluorophenyl acrylate (manufactured by Tokyo Chemical Industry) C6(meth)acrylate, C4(meth)acrylate, C2(meth)acrylate (manufactured by Unichem) Viscoat 3F, Viscoat 4F, Viscoat 8F, Viscoat 8FM, Viscoat 13F (manufactured by OSAKA ORGANIC CHEMICAL INDUSTRY) 1H,1H,2H,2H-heptadecafluorodecyl methacrylate, 1,1,1,3,3,3-hexafluoroisopropyl methacrylate, 1H,1H,5H-octafluoropentyl methacrylate, pentafluorophenyl acrylate, 2,2,2-trifluoroethyl acrylate, 2,2,2-trifluoroethyl methacrylate (manufactured by Polysciences) methyl-2-fluoroacrylate, 2,2,2-trifluoroethyl acrylate, 2,2,3,3,3-pentafluoropropyl acrylate, 2-(perfluorobutyl)ethyl acrylate, 3-perfluorohexyl-2-hydroxypropyl acrylate, 1H,1H,3H-tetrafluoropropyl acrylate, 1H,1H,5H-octafluoropentyl acrylate, 1H,1H,7H-dodecafluoroheptyl acrylate, 1H-1-(trifluoromethyl)trifluoroethyl acrylate, 1H,1H,3H-hexafluorobutyl acrylate, 2,2,2-trifluoroethyl methacrylate, 2,2,3,3,3-pentafluoropropyl methacrylate, 2-(perfluorobutyl)ethyl methacrylate, 1H,1H,3H-tetrafluoropropyl methacrylate, 1H,1H,5H-octafluoropentyl methacrylate, 1H,1H,7H-dodecafluoroheptyl methacrylate, 1H-1-(trifluoromethyl)trifluoroethyl methacrylate, 1H,1H,3H-hexafluorobutyl methacrylate (manufactured by DAIKIN)

Examples of the above-described fluorine-containing polyfunctional (meth)acrylate-based compound obtained using a method disclosed in Japanese Patent No. 3963028 are as follows, but the compound is not limited to these examples.

A compound obtained by introducing a linking group to the polyalcohol part of trivalent trimethylolethane, quadrivalent pentaerythritol, or hexavalent dipentaerythritol using a normal organic synthetic reaction, forming a core part containing fluorine in high content by a whole fluorination reaction, and then introducing an acrylic group to an end.

Also, a commercially available product may be used as the curable composition (A), and examples are PAK-TRAD manufactured by TOYO GOSEI and UT-UCaf68 manufactured by AGC Seimi Chemical.

### <Arranging Step>

In the arranging step, as schematically shown in Fig. 4B, droplets 102 of the curable composition (A) are discretely arranged on the master mold MM.

As an arranging method of arranging the droplets 102 of the curable composition (A) on the master mold MM, an inkjet method is particularly preferable. The droplets 102 of the curable composition (A) are densely arranged on a region where concave portions that form the fine pattern FP of the master mold MM densely exist, and coarsely arranged on a region where concave portions that form the fine pattern FP of the master mold MM coarsely exist. Hence, a residual film in the cured film of the curable composition (A) formed on the master mold MM is controlled to an even thickness regardless of whether the fine pattern FP of the master mold MM is dense or coarse.

### <Waiting Step>

The waiting step is provided after the arranging step and before the contact step (between the arranging step and the contact step). The waiting step is, for example, 0.1 sec to 600 sec, and preferably 10 sec to 300 sec. In the waiting step, as schematically shown in Figs. 4C and 4D, the droplets 102 of the curable composition (A) spread on the master mold MM, and the droplets combine with each other, and a practically continuous liquid film 103 is formed. The state of the curable composition (A) as shown in Fig. 4D is called "a practically continuous liquid film". Note that if the curable composition (A) contains the solvent (d), in the waiting step, the solvent (d) contained in the liquid film 103 is volatilized, as schematically shown in Fig. 4E.

In the waiting step, it is possible to perform a baking step of heating the master mold MM and the curable composition (A), or ventilate the atmospheric gas around the master mold MM, for the purpose of accelerating the volatilization of the solvent (d). The heating is performed at, for example, 30°C or more and 200°C or less, preferably 80°C or more and 150°C or less, and particularly preferably 90°C or more and 110°C or less. The heating time can be 10 sec or more and 600 sec or less. The baking step can be performed by using a known heater such as a hotplate or an oven.

### <Contact Step>

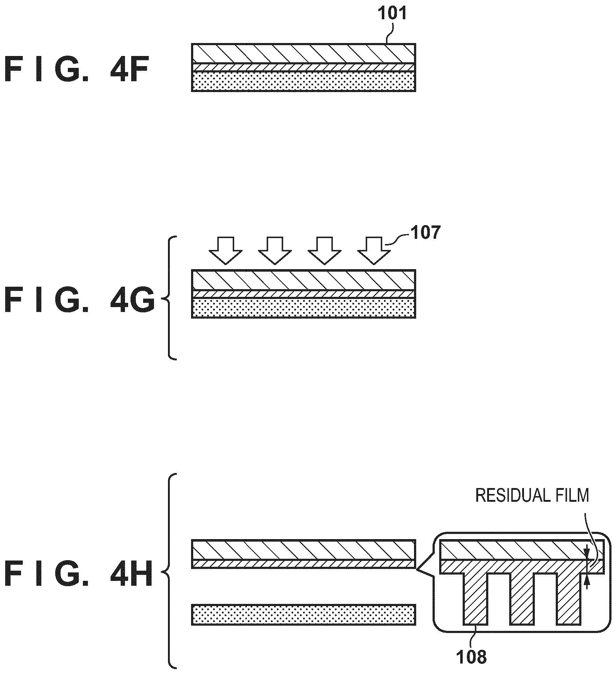

In the contact step, as schematically shown in Fig. 4F, the practically continuous liquid film 103 of the curable composition (A) on the master mold MM (the curable composition from which the solvent (d) is removed) is brought into contact with a replica base material 101 (convex portion 14) that is the high elastic modulus part 10. The contact step includes a step of a changing a state in which the curable composition (A) on the master mold MM and the replica base material 101 are not in contact with each other to a state in which they are in contact with each other, and a step of maintaining the state in which they are in contact with each other.

The replica base material 101 preferably has a size of 152.4 mm (6 inches) square and a thickness of 6.35 mm. Also, as the material of the replica base material 101, a high elastic modulus material having an elastic modulus of 50 GPa or more is preferable, more specifically, silica glass is preferable. Silica glass is available as a high-quality photomask base material in the semiconductor industry and has a high use result.

The contact step is preferably 0.1 sec or more and 600 sec or less, and particularly preferably 0.1 sec or more and 10 sec or less. If the contact step is shorter than 0.1 sec, contact between the curable composition (A) on the master mold MM and the replica base material 101 may be insufficient.

In the contact step, the pressure to be applied to the curable composition (A) when bringing the replica base material 101 into contact with the curable composition (A) on the master mold MM is not particularly limited, and is, for example, 0 MPa or more and 100 MPa or less. Note that when bringing the replica base material 101 into contact with the curable composition (A) on the master mold MM, the pressure to be applied to the curable composition (A) is preferably 0 MPa or more and 50 MPa or less. Also, when bringing the replica base material 101 into contact with the curable composition (A) on the master mold MM, the pressure to be applied to the curable composition (A) is more preferably 0 MPa or more and 30 MPa or less, and further preferably 0 MPa or more and 20 MPa or less.

The contact step can be performed in any of a normal air atmosphere, a reduced-pressure atmosphere, and an inert-gas atmosphere. However, the reduced-pressure atmosphere or the inert-gas atmosphere is favorable because it is possible to prevent the influence of oxygen or water on the curing reaction. Practical examples of an inert gas to be used when performing the contact step in the inert-gas atmosphere are nitrogen, carbon dioxide, helium, argon, various freon gases, and gas mixtures thereof. When performing the contact step in a specific gas atmosphere including a normal air atmosphere, a favorable pressure is 0.0001 atm or more and 10 atm or less.

### <Curing Step>

In the curing step, as schematically shown in Fig. 4G, the liquid film 103 of the curable composition (A) is cured by being irradiated with irradiation light 107 as curing energy, thereby forming a cured film. In the curing step, for example, the liquid film 103 of the curable composition (A) is irradiated with the irradiation light 107 through the replica base material 101. More specifically, the curable composition (A) filled in the fine pattern FP of the master mold MM is irradiated with the irradiation light 107 through the replica base material 101. Consequently, the curable composition (A) filled in the fine pattern FP of the master mold MM is cured and forms a cured film 108 having the pattern.

The irradiation light 107 is selected in accordance with the sensitivity wavelength of the curable composition (A). More specifically, the irradiation light 107 is properly selected from ultraviolet light, X-ray, and an electron beam each having a wavelength of 150 nm or more and 400 nm or less. Note that the irradiation light 107 is particularly preferably ultraviolet light. This is so because many compounds commercially available as curing assistants have sensitivity to ultraviolet light. Examples of a light source that emits ultraviolet light are a high-pressure mercury lamp, an ultrahigh-pressure mercury lamp, a low-pressure mercury lamp, a Deep-UV lamp, a carbon arc lamp, a metal halide lamp, a xenon lamp, a KrF excimer laser, an ArF excimer laser, and an F₂ laser. Note that the ultrahigh-pressure mercury lamp is particularly favorable as the light source for emitting ultraviolet light. It is possible to use one light source or a plurality of light sources. Light can be emitted to the entire region of the curable composition (A) filled in the fine pattern FP of the master mold MM, or to only a partial region thereof (by limiting the region). It is also possible to intermittently emit light to the entire region of the replica base material 101 (convex portion 14) a plurality of times, or to continuously emit light to the entire region of the replica base material 101. Furthermore, a first region of the replica base material 101 can be irradiated with light in a first irradiation process, and a second region different from the first region of the replica base material 101 can be irradiated with light in the second irradiation process.

### <Mold Release Step>

In the mold release step, as schematically shown in Fig. 4H, the master mold MM is released from the cured film 108. By releasing the cured film 108 having a pattern and the master mold MM from each other, the cured film 108 having a pattern formed by inverting the fine pattern FP of the master mold MM is obtained in an independent state on the replica base material 101. Here, a film remains in the concave portions of the cured film 108 having the pattern corresponding to the pattern FP of the master mold MM. This film is called a residual film.

The thickness of the residual film is 0.1 µm or more and 1,000 µm or less. The thickness of the low elastic modulus part 31 is defined as a thickness corresponding to the sum of the thickness of the residual film and the height of the pattern. The thicker the residual film is, the higher the followability to a foreign substance existing on a device substrate in imprint processing (device imprint) for manufacturing various kinds of devices is. The residual film preferably has a thickness about 10 times a foreign substance assumed to exist on the device substrate. For example, if the height of a foreign substance existing on the device substrate is assumed to be about 0.1 µm, the residual film preferably has a thickness of 1 µm or more. Also, if the height of a foreign substance existing on the device substrate is assumed to be about 1 µm, the residual film preferably has a thickness of 10 µm or more. Also, if the height of a foreign substance existing on the device substrate is assumed to be about 10 µm, the residual film preferably has a thickness of 100 µm or more.

A method of releasing the master mold MM from the cured film 108 having the pattern can be any method provided that the method does not physically break a part of the cured film 108 having the pattern during the release, and various conditions and the like are not particularly limited. For example, it is possible to fix the replica base material 101 and move the master mold MM away from the replica base material 101. It is also possible to fix the master mold MM and move the replica base material 101 away from the master mold MM. Furthermore, the master mold MM can be released from the cured film 108 having the pattern by moving both the master mold MM and the replica base material 101 in exactly opposite directions.

### [Imprint Processing]

A film forming method according to one aspect of the present invention will be described. In this embodiment, the film forming method is executed as imprint processing (imprint method) using a replica mold by forming a film of a curable composition in a space between the replica mold and a substrate. Also, imprint processing is executed as a pattern forming method of forming a film having a pattern.

First, before execution of imprint processing, replica molds shown in Example 1 and Comparative Examples 1, 2, and 3 below are manufactured (prepared).

### (Example 1)

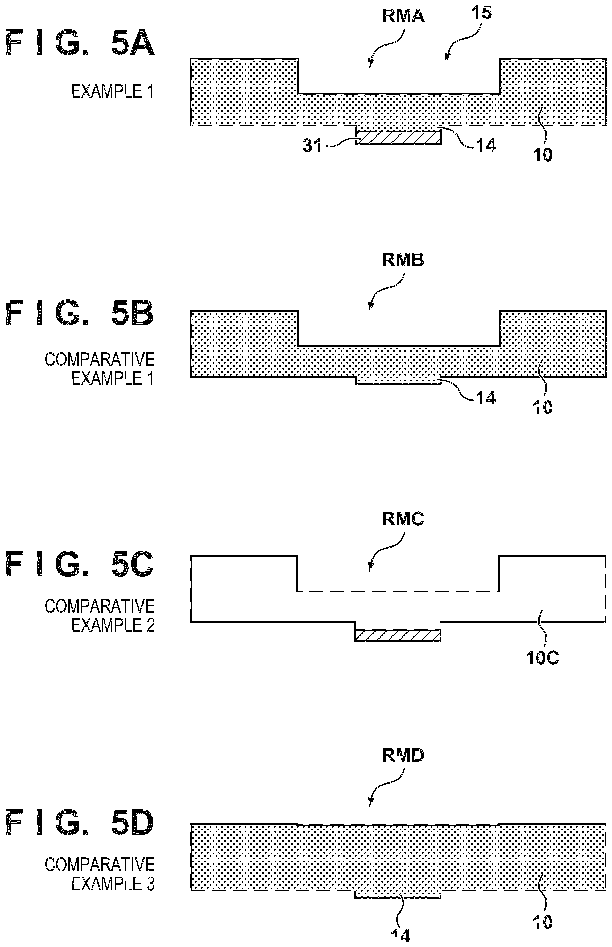

As Example 1, a replica mold RMA shown in Fig. 5A is manufactured. A high elastic modulus part 10 that is a replica base material has a size of 152.4 mm square and a thickness of 6.35 mm. A convex portion 14 having a height of 30 µm and an area of 26 mm × 33 mm is provided at the center portion (pattern region 13) of a first surface 11. A second surface 12 of the high elastic modulus part 10 has a circular concave portion 15 with a diameter of 60 mm, which overlaps the convex portion 14 (pattern region 13) and has an area larger than that of the convex portion 14. The thickness of the portion of the concave portion 15 of the high elastic modulus part 10 is 1 mm. The high elastic modulus part 10 is made of synthetic silica glass having an elastic modulus of about 72 GPa.

To improve the adhesion to the curable composition (A), acryloxypropyltrimethoxysilane that is an acrylic group-containing silane coupling agent is vapor-deposited on the convex portion 14 of the high elastic modulus part 10.

As a master mold MM, a mold that is made of a silicon wafer with a diameter of 300 mm and has an area of 26 mm × 33 mm with a fine pattern FP formed at the center portion is prepared.

The curable composition (A) containing a fluorine-containing polymerizable compound (at) is dropped by an inkjet method to the portion of the fine pattern FP of the master mold MM such that the thickness of a residual film is 100 µm, thereby forming a liquid film.

The convex portion 14 (pattern region 13) of the high elastic modulus part 10 that is the replica base material is brought into contact with the liquid film of the curable composition (A) on the master mold MM, and the curable composition (A) is irradiated with ultraviolet light through the high elastic modulus part 10 and thus cured. Accordingly, a low elastic modulus part 31 having a film thickness of 100 µm is formed on the convex portion 14 of the high elastic modulus part 10. The elastic modulus of the low elastic modulus part 31 is about 3 GPa.

### (Comparative Example 1)

A replica mold RMB shown in Fig. 5B is manufactured as Comparative Example 1. The replica mold RMB does not include a low elastic modulus part 31. Synthetic silica glass having the same structure as in Example 1 is prepared as a high elastic modulus part 10 that is a replica base material. A fine pattern is formed by an electron beam lithography technique on a convex portion 14 of a high elastic modulus part 10.

### (Comparative Example 2)

A replica mold RMC shown in Fig. 5C is manufactured as Comparative Example 2. In the replica mold RMC, both a part 10C having the same shape as a high elastic modulus part 10 and a low elastic modulus part 31 have a second elastic modulus. As the part 10C that is a replica base material and the low elastic modulus part 31, polycarbonate having the same structure as in Example 1 is prepared. A fine pattern is formed by an electron beam lithography technique on the convex portion (mesa structure) of the low elastic modulus part 31 (polycarbonate). The second elastic modulus is about 3 GPa.

### (Comparative Example 3)

A replica mold RMD shown in Fig. 5D is manufactured as Comparative Example 3. The replica mold RMD does not include a concave portion 15. A high elastic modulus part 10 that is a replica base material has a size of 152.4 mm square and a thickness of 6.35 mm, and a convex portion 14 having a height of 30 µm and an area of 26 mm × 33 mm is provided at the center portion (pattern region 13) of a first surface 11. A second surface 12 of the high elastic modulus part 10 does not include the concave portion 15. A fine pattern is formed by an electron beam lithography technique on the convex portion 14 of the high elastic modulus part 10.

### (Device Imprint)

Imprint processing (device imprint) for manufacturing various kinds of devices is performed using the replica molds RMA (Example 1), RMB (Comparative Example 1), RMC (Comparative Example 2), and RMD (Comparative Example 3). The imprint processing includes, for example, an arranging step, a waiting step, a contact step, a curing step, and a mold release step. The arranging step is a step of discretely arranging droplets for device imprint on a device substrate. The waiting step is a step of waiting until the droplets for device imprint combine with each other. The contact step is a step of bringing the curable composition for device imprint into contact with the replica mold. The curing step is a step of curing the curable composition for device imprint. The mold release step is a step of releasing the replica mold from the cured film of the curable composition for device imprint. The waiting step is executed after the arranging step, the contact step is executed after the waiting step, the curing step is executed after the contact step, and the mold release step is executed after the curing step.

As the device substrate, a silicon wafer having a diameter of 300 mm is prepared. The curable composition for device imprint is dropped by the inkjet method to form a liquid film on one shot region (one field) of the silicon wafer (the arranging step and the waiting step).

In the contact step, as schematically shown in Fig. 6A, the concave portion 15 of the replica mold is sealed to form a sealed space, a nitrogen gas is supplied to the sealed space, and the pressure in the sealed space is set to 1.5 atm. Thus, the concave portion 15 is bent to curve (deform) (the convex portion 14 of) the replica mold (and the low elastic modulus part 31 formed on the convex portion 14) into a convex shape to the side of the device substrate. Note that as a sealing mechanism configured to change the concave portion 15 to the sealed space, for example, a holding unit that holds the replica mold can be used. The holding unit may include a seal member such as a seal glass used to change the concave portion 15 to the sealed space. Next, as schematically shown in Fig. 6B, the replica mold is lowered in a state in which it is curved, and only the center portion of (the convex portion 14 of) the replica mold (and the low elastic modulus part 31 formed on the convex portion 14) is brought into contact with the curable composition on the device substrate. Also, as schematically shown in Fig. 6C, while applying a pressing force of 42 N at maximum, the replica mold is sequentially brought into contact with the curable composition on the device substrate from the center portion of the replica mold to the outer peripheral portion. Then, as schematically shown in Fig. 6D, when the whole (pattern region 13) of the replica mold comes into contact with the curable composition on the device substrate, the pressure in the sealed space is released up to the atmospheric pressure (1 atm) to cancel the bend of the replica mold.

As described above, in the contact step, the concave portion 15 of the high elastic modulus part 10 is bent, thereby bringing the center portion of the fourth surface 31b of the low elastic modulus part 31 into contact with the liquid film of the curable composition on the device substrate. After the center portion of the fourth surface 31b of the low elastic modulus part 31 is brought into contact with the liquid film of the curable composition, the bend of the concave portion 15 is canceled, thereby bringing the whole surface of the fourth surface 31b of the low elastic modulus part 31 into contact with the liquid film of the curable composition on the device substrate.

In the curing step, the curable composition on the device substrate is irradiated with ultraviolet light as curing energy through the replica mold and thus cured.

In the mold release step, the replica mold is released from the cured film of the curable composition on the device substrate. Thus, a cured film having a pattern obtained by inverting the pattern of the replica mold is formed on the device substrate.

### (Analysis of Following Behavior to Foreign Substance)

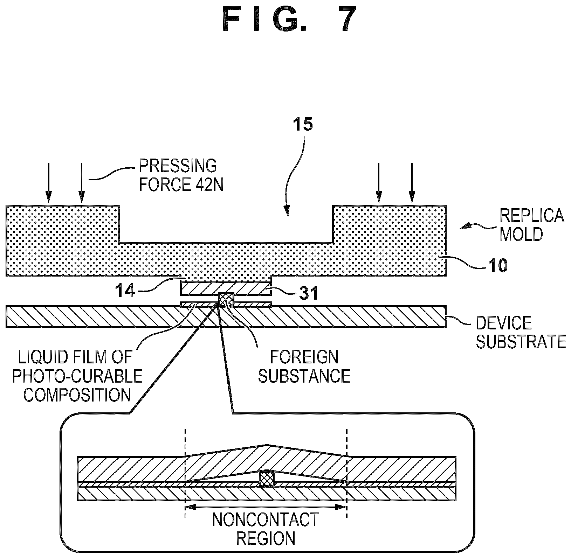

An analysis model of the following behavior of the replica mold to a foreign substance existing on the device substrate will be described with reference to Fig. 7. A liquid film of a curable composition having an average thickness of 50 nm is formed in a 26 mm × 33 mm shot region of a silicon wafer that serves as a device substrate and has a diameter of 300 mm and an elastic modulus of 190 GPa. Assume that a columnar foreign substance having a diameter of 10 µm and a height of 10 µm exists at the center portion of the liquid film on the shot region of the device substrate. In a case where the replica mold was brought into contact with the shot region at a pressing force of 42 N, the following behavior (deformation) of each of the replica molds according to Example 1 and Comparative Examples 1, 2, and 3 was analyzed. A meniscus pressure caused by the liquid film sandwiched between the replica mold and the silicon wafer was calculated as 1.18 MPa. Since the replica mold was attracted to the side of the silicon wafer by the meniscus pressure, the influence was also taken into consideration. In the analysis model, the radius of a noncontact region generated between the replica mold and the silicon wafer due to the sandwiched foreign substance was calculated. It is determined that the smaller the radius of the noncontact region is, the higher the followability to the foreign substance is. For the analysis, finite element analysis software Abaqus available from Dassault Systemes was used.

For Example 1, device imprint (pressing) could be performed without sandwiching the atmospheric gas between the replica mold RMA and the silicon wafer. The radius of the noncontact region formed around the foreign substance was 163 µm.

For Comparative Example 1, device imprint (pressing) could be performed without sandwiching the atmospheric gas between the replica mold RMB and the silicon wafer. The radius of the noncontact region formed around the foreign substance was 540 µm.

For Comparative Example 2, device imprint (pessing) could be performed without sandwiching the atmospheric gas between the replica mold RMC and the silicon wafer. The radius of the noncontact region formed around the foreign substance was 220 µm.

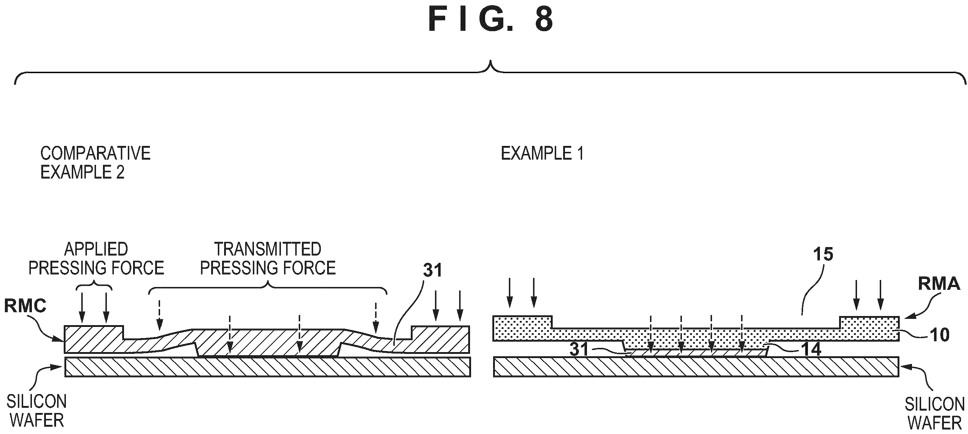

The difference of the following behavior of the replica mold to the foreign substance between Example 1 and Comparative Example 2 will be described here with reference to Fig. 8. In Comparative Example 2, since the whole replica mold RMC is made of a low elastic modulus material having an elastic modulus of about 3 GPa, the pressing force is consumed to deform the concave portion of the replica mold RMC. On the other hand, in Example 1, since the concave portion 15 (replica base material) of the replica mold RMA is made of a high elastic modulus material having an elastic modulus of about 72 GPa, the pressing force consumed to deform the concave portion 15 is small, and the pressing force is transmitted to the convex portion 14. Hence, in the low elastic modulus part 31 formed on the convex portion 14 of the replica mold RMA, the following behavior to the foreign substance is improved, as compared to Comparative Example 2.

For Comparative Example 3, in device imprint (pressing), the atmospheric gas was sandwiched between the replica mold RMD and the silicon wafer. This is because synthetic silica glass having a thickness of 6.35 mm cannot be curved at 1.5 atm. Analysis of the following behavior to the foreign substance was not conducted.

As described above, according to this embodiment, it is possible to provide a replica mold with improved followability to a foreign substance. Hence, even if a foreign substance exists on a substrate, the noncontact region where the curable composition on the substrate and the replica mold are not in contact is reduced, and the transfer pattern of the replica mold can accurately be transferred. In addition, since it is unnecessary to apply a large pressing force to the replica mold, the possibility that the transfer pattern of the replica mold is compressed by the foreign substance and broken can be reduced.

### [Imprint Apparatus]

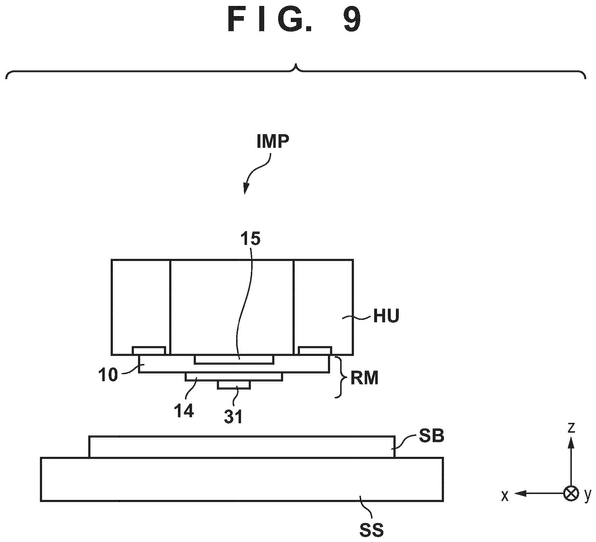

Fig. 9 is a schematic view illustrating the configuration of an imprint apparatus IMP according to an aspect of the present invention. The imprint apparatus IMP is a lithography apparatus that forms a pattern on a substrate. The imprint apparatus IMP brings a curable composition (replica material) arranged on a substrate into contact with a replica mold, and applying curing energy to the curable composition, thereby forming a pattern of a cured product to which the pattern of the replica mold is transferred.

The imprint apparatus IMP includes a holding unit HU that holds a replica mold RM, and a substrate stage SS that holds a substrate SB. The imprint apparatus IMP also includes a supply unit including a dispenser configured to arrange (supply) a curable composition on the substrate, a bridge surface plate configured to hold the holding unit HU, and a base surface plate configured to hold the substrate stage SS.

The replica mold RM is a mold that forms the curable composition on the substrate. As described above, the replica mold RM includes a high elastic modulus part 10 including a convex portion 14 and a concave portion 15, and a low elastic modulus part 31 combined to (formed on) the convex portion 14 to which a transfer pattern is formed.

The holding unit HU is a holding mechanism that holds the replica mold RM. The holding unit HU includes, for example, a chuck that vacuum-sucks or electrostatically attracts the replica mold RM, and a mold driving unit that drives the chuck. The mold driving unit drives (moves) the chuck sucking the replica mold RM, that is, the replica mold RM in the X direction, the Y direction, the Z direction, and the θZ direction.

The substrate stage SS is a holding mechanism that holds the substrate SB to which the transfer pattern of the replica mold RM is transferred. The substrate stage SS, for example, vacuum-sucks or electrostatically attracts the substrate SB via the chuck, and is driven by a substrate driving unit. The substrate driving unit drives the substrate stage SS holding the substrate SB, that is, the substrate SB in the X direction, the Y direction, the Z direction, and the θZ direction.

In the imprint apparatus IMP, in a state in which the curable composition on the substrate and the replica mold RM are in contact, ultraviolet light for curing the curable composition is emitted from the upper side of the apparatus. The curable composition on the substrate is thus cured. After that, when the replica mold RM is released, a cured film (cured product) of the curable composition to which the transfer pattern of the replica mold RM is transferred is formed on the substrate.

The pattern of a cured product formed using the imprint apparatus IMP is used permanently for at least some of various kinds of articles or temporarily when manufacturing various kinds of articles. The articles are an electric circuit element, an optical element, a MEMS, a recording element, a sensor, a mold, and the like. Examples of the electric circuit element are volatile and nonvolatile semiconductor memories such as a DRAM, a SRAM, a flash memory, and a MRAM and semiconductor elements such as an LSI, a CCD, an image sensor, and an FPGA. Examples of the mold are molds for imprint. Examples of the optical element are light extraction structures such as a quantum dot struct, a sub-wavelength antireflection structure, and an LED, a photonic crystal, a wire grid polarizing plate for UV region, a structural birefringent wavelength plate, a diffraction grating, and a metalens.

The pattern of the cured product is directly used as the constituent member of at least some of the above-described articles or used temporarily as a resist mask. After etching or ion implantation is performed in the substrate processing step, the resist mask is removed.

### [Article Manufacturing Method]

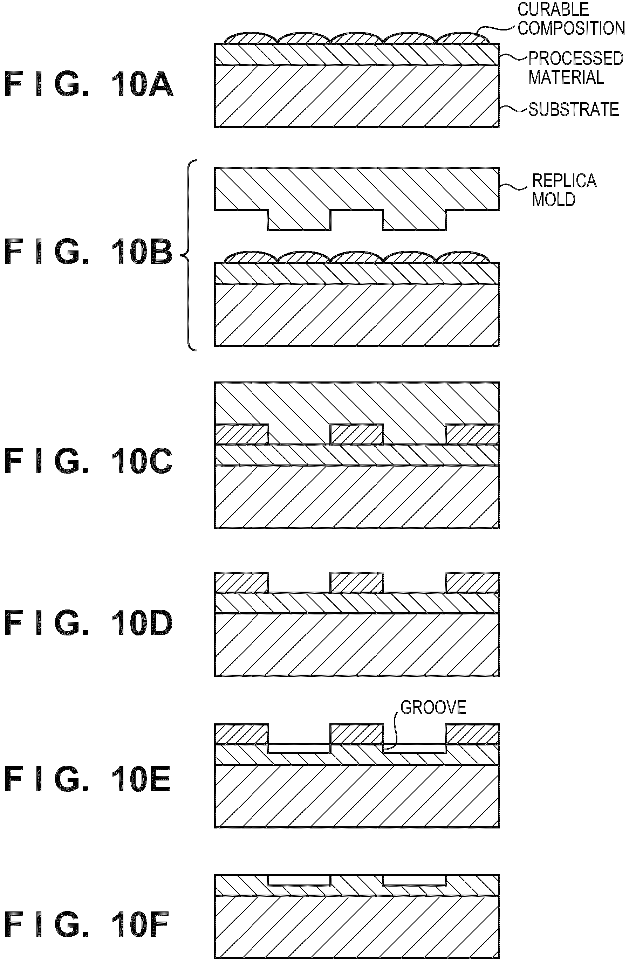

Description regarding a detailed method of manufacturing an article is given. As illustrated in Fig. 10A, the substrate such as a silicon wafer with a processed material such as an insulator formed on the surface is prepared. Next, an imprint material is applied to the surface of the processed material by an inkjet method or the like. A state in which the imprint material is applied as a plurality of droplets onto the substrate is shown here.

As shown in Fig. 10B, a side of the replica mold with a projection and groove pattern is formed on and caused to face the imprint material on the substrate. As illustrated in Fig. 10C, the substrate to which the imprint material is applied is brought into contact with the replica mold, and a pressure is applied. The gap between the replica mold and the processed material is filled with the imprint material. In this state, when the imprint material is irradiated with light serving as curing energy through the replica mold, the imprint material is cured.

As shown in Fig. 10D, after the imprint material is cured, the replica mold is released from the substrate. Thus, the pattern of the cured product of the imprint material is formed on the substrate. In the pattern of the cured product, the groove of the replica mold corresponds to the projection of the cured product, and the projection of the replica mold corresponds to the groove of the cured product. That is, the projection and groove pattern of the replica mold is transferred to the imprint material.

As shown in Fig. 10E, when etching is performed using the pattern of the cured product as an etching resistant mask, a portion of the surface of the processed material where the cured product does not exist or remains thin is removed to form a groove. As shown in Fig. 10F, when the pattern of the cured product is removed, an article with the grooves formed in the surface of the processed material can be obtained. The pattern of the cured material is removed here, but, for example, the pattern may be used as a film for insulation between layers included in a semiconductor element or the like without being removed after processing, in other words as a constituent member of the article.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A mold comprising a first part and a second part, wherein
the first part includes a first surface including a plane, and a second surface on an opposite side of the first surface,
the second surface includes, at a center portion, a concave portion having a concave shape,
the first surface includes, at a center portion, a convex portion projecting from the plane and having a convex shape,
the second part includes a third surface combined to the convex portion of the first part, and a fourth surface on the opposite side of the third surface, on which a pattern to be transferred to a transfer target is formed,
the first part is made of a material having a first elastic modulus, and
the second part is made of a material having a second elastic modulus lower than the first elastic modulus.

2. The mold according to claim 1, wherein the convex portion is located in a region inside an outer edge of a region formed by orthogonally projecting the concave portion to a virtual plane parallel to the plane.

3. The mold according to claim 1, wherein
the first elastic modulus is not less than 20 GPa, and
the second elastic modulus is not more than 10 GPa.

4. The mold according to claim 1, wherein a distance between the plane of the first surface and a surface of a portion of the second surface where the concave portion does not exist is 6.35 mm ± 0.10 mm.

5. The mold according to claim 1, wherein a distance between the plane of the first surface and a bottom portion of the concave portion is not less than 0.1 mm and not more than 3 mm.

6. The mold according to claim 1, wherein the convex portion has a height larger than 0 µm and not more than 1,000 µm.

7. The mold according to claim 1, wherein the second part has a thickness not less than 0.1 µm and not more than 1,000 µm.

8. The mold according to claim 1, wherein the convex portion has an area not less than 0.5% and not more than 30% an area of the first surface.

9. The mold according to claim 1, wherein the mold includes a replica mold.

10. A manufacturing method of manufacturing a mold including a first part and a second part, comprising
forming, using an imprint method, the second part on a convex portion of the first part including a first surface including a plane, and a second surface on an opposite side of the first surface, the second surface including, at a center portion, a concave portion having a concave shape, and the first surface including, at a center portion, the convex portion projecting from the plane and having a convex shape,
wherein in the forming, a pattern to be transferred to a transfer target is formed on a fourth surface on the opposite side of a third surface of the second part, which is combined to the convex portion of the first part,
the first part is made of a material having a first elastic modulus, and
the second part is made of a material having a second elastic modulus lower than the first elastic modulus.

11. A film forming method of forming, using a mold defined in claim 1, a film of a curable composition in a space between the mold and a substrate, comprising:
discretely arranging a plurality of droplets of the curable composition on the substrate;
waiting until the plurality of droplets combine with adjacent droplets to form a liquid film; and
after the waiting, bringing the mold and the liquid film into contact with each other,
wherein in the bringing the mold and the liquid film into contact with each other, a center portion of a fourth surface of a second part of the mold is brought into contact with the liquid film by bending a concave portion of a second surface of a first part of the mold, and after the center portion is brought into contact with the liquid film, a whole surface of the fourth surface is brought into contact with the liquid film by canceling a bend of the concave portion.

12. An article manufacturing method comprising:
forming a film of a curable composition on a substrate using a film forming method defined in claim 11;
processing the substrate on which the film is formed in the forming; and
manufacturing an article from the substrate processed in the processing.

13. An imprint apparatus for forming a pattern of a curable composition on a substrate, comprising
a holding unit configured to hold a mold defined in claim 1.
